# EUROPEAN PATENT APPLICATION

(11) **EP 4 807 381 A1**
(43) Date of publication of application: **16.09.2026**
(21) Application number: 26159800.7
(22) Date of filing: 20.02.2026
(51) Int. Cl.: G01R 31/42, G01R 31/52, H02M 1/12

(54) **POWER CONVERTER, METHOD AND APPARATUS FOR INSULATION DETECTION THEREOF**

(30) Priority: 11.03.2025 CN 202510288245
(71) Applicant: Sungrow Power Supply Co., Ltd., Hefei, Anhui 230088 (CN)
(72) Inventor: HU, Fanyu, Hefei, Anhui, 230088 (CN); CAO, Jinhu, Hefei, Anhui, 230088 (CN)
(74) Representative: Prinz & Partner mbB

(57) **Abstract**

Disclosed are a power converter (10), a method and apparatus for insulation detection thereof. The power converter (10) is provided with a switch between a node at which two alternating-current switches in any phase of an alternating-current side of the power converter are connected in series to each other and a virtual neutral point of the alternating-current side. The switch may be turned on while a second alternating-current switch connected thereto being turned on, to provide an alternating-current side detection loop for detecting the insulation impedance between an alternating-current side neutral point of the power converter and ground. The switch may also be turned on while a first alternating-current switch connected thereto being turned on and at least one switching transistor in the power converter being turned on, to provide a direct-current side detection loop for detecting the insulation impedance of the direct-current side of the power converter.

## Description

### FIELD

The present disclosure relates to the technical field of insulation detection, and in particular to a power inverter, and a method and apparatus for insulation detection thereof.

### BACKGROUND

In order to improve the reliability of a power conversion system, it is necessary to monitor an impedance short-circuit fault of the power conversion system to ground. In related technologies, insulation impedance on an alternating-current (AC) side and a direct-current (DC) side of the power conversion system to ground are usually detected separately to determine whether a short-circuit fault exists in the power conversion system to ground. In this solution, in order to obtain the insulation condition on both the AC side and the DC side of the power conversion system to ground, two separate apparatuses are required to measure the insulation impedance on the DC side and the AC side of the power conversion system to ground respectively, which therefore results in a relatively high detection cost.

### SUMMARY

In view of the above, a power converter, a method and apparatus for insulation detection thereof are provided in the present disclosure, to reduce the detection cost of insulation detection on an alternating-current and a direct-current side of the power converter to ground.

In a first aspect, a power converter is provided according to embodiments of the present disclosure. The power converter includes: a controller, a DC/AC conversion circuit, an insulation resistor to ground, an insulation detection circuit, and at least one sampling resistor. A direct-current side of the DC/AC conversion circuit is configured to connect a direct-current side of the power converter. Each phase of an alternating-current side of the DC/AC conversion circuit is connected to a corresponding phase of an external device in sequence through a corresponding first alternating-current switch and a corresponding second alternating-current switch. Each phase of an alternating-current side of the power converter is connected to a virtual neutral point through a corresponding sampling resistor. The virtual neutral point is grounded through the insulation resistor. The insulation detection circuit includes a switch, and two ends of the switch are respectively connected to the virtual neutral point and a connection point between two alternating-current switches in one phase of the DC/AC conversion circuit. The DC/AC conversion circuit and the switch are controlled by the controller. The switch is configured to: be controlled to be turned on while the second alternating-current switch connected to the switch being turned on, to provide an alternating-current side detection loop for detecting the insulation impedance between an alternating-current side neutral point of the power converter and ground; and be controlled to be turned on while the first alternating-current switch connected to the switch being turned on and at least one switching transistor in the DC/AC conversion circuit being turned on, to provide a direct-current side detection loop for detecting the insulation impedance of the direct-current side of the power converter.

In an embodiment, the insulation detection circuit further includes:
a first resistor, wherein the first resistor is connected between the switch and the virtual neutral point, or, the first resistor is connected between the switch and a node at which the two alternating-current switches are connected in series to each other.

In an embodiment, the power converter further includes:
a second resistor and a third resistor, wherein
the second resistor is connected between a positive electrode of the direct-current side of the DC/AC conversion circuit and the ground, and
the third resistor is connected between a negative electrode of the direct-current side of the DC/AC conversion circuit and the ground.

In an embodiment, the DC/AC conversion circuit includes:
one single-phase inverter topology;
three single-phase inverter topologies; or
a three-phase full-bridge inverter topology.

In an embodiment, the power converter further includes:
at least one DC/DC conversion circuit, wherein
a first side of the DC/DC conversion circuit is configured to connect to a corresponding interface of the direct-current side of the power converter;
a second side of the DC/DC conversion circuit is connected to the direct-current side of the DC/AC conversion circuit; and
the DC/DC conversion circuit is controlled by the controller.

In an embodiment, the first alternating-current switch and the second alternating-current switch are provided inside or outside the power converter.

In a second aspect, a method for insulation detection of a power converter is provided according to embodiments of the present disclosure. The method is applied to the power converter according to the first aspect of the present disclosure. The method includes:
controlling, according to an insulation detection requirement, switching states of each switching transistor of the power converter, each alternating-current switch and the switch of the insulation detection circuit, the insulation detection requirement being a requirement for detecting the insulation impedance of the direct-current side of the power converter or the insulation impedance between the alternating-current side neutral point of the power converter and the ground;
acquiring detection parameters of the power converter;
calculating the insulation impedance under the insulation detection requirement in accordance with the detection parameters.

In an embodiment, the insulation detection requirement is the requirement for detecting the insulation impedance between the alternating-current side neutral point of the power converter and the ground, the controlling the switching states of each switching transistor of the power converter, each alternating-current switch and the switch of the insulation detection circuit includes:
controlling the switch and the second alternating-current switch connected the switch to be turned on, and controlling each switching transistor and the first alternating-current switch connected to the switch to be turned off.

In an embodiment, the insulation detection requirement is the requirement for detecting the insulation impedance of the direct-current side of the power converter, the controlling the switching states of each switching transistor of the power converter, each alternating-current switch and the switch of the insulation detection circuit includes:
controlling the switch, the first alternating-current switch connected to the switch and at least one switching transistor to be turned on, and controlling switching transistors other than said at least one switching transistor and the second alternating-current switch connected to the switch to be turned off.

In an embodiment, the controlling the switch, the first alternating-current switch connected to the switch and the at least one switching transistor to be turned on includes:
when detecting the insulation impedance between a positive electrode of the direct-current side of the power converter and the ground, controlling the switch and the first alternating-current switch connected to the switch to be turned on, and controlling a switching transistor of a bridge arm of a corresponding phase of the DC/AC conversion circuit of the power converter that provides a direct-current side positive electrode detection loop for the insulation impedance between the positive electrode of the direct-current side of the power converter and the ground to be turned on; and
when detecting the insulation impedance between a negative electrode of the direct-current side of the power converter and the ground, controlling the switch and the first alternating-current switch connected to the switch to be turned on, and controlling a switching transistor in a bridge arm of a corresponding phase of the DC/AC conversion circuit that provides a direct-current side negative electrode detection loop for the insulation impedance between the negative electrode of the direct-current side of the power converter and the ground to be turned on.

In an embodiment, the DC/AC conversion circuit includes an ANPC-type three-level inverter topology;
the switching transistor that provides the direct-current side positive electrode detection loop for the insulation impedance between the positive electrode of the direct-current side of the power converter and the ground is: a clamping transistor at an upper bridge arm, an inner transistor at a lower bridge arm, or both an inner transistor and an outer transistor at a lower bridge arm; and
the switching transistor that provides the direct-current side negative electrode detection loop for the insulation impedance between the negative electrode of the direct-current side of the power converter and the ground is: an inner transistor at an upper bridge arm, a clamping transistor at a lower bridge arm, or both an inner transistor and an outer transistor at an upper bridge arm.

In an embodiment, the insulation detection requirement varies at different time instants, including:
a requirement for detecting the insulation impedance of the direct-current side of the power converter; and
a requirement for detecting the insulation impedance between the alternating-current side neutral point of the power converter and the ground.

In an embodiment, when the insulation detection requirement is the requirement for detecting the insulation impedance between the alternating-current side neutral point of the power converter and the ground, after calculating the insulation impedance under the insulation detection requirement, the method further includes:
determining, according to the calculated insulation impedance between the alternating-current side neutral point of the power converter and the ground, a type of an alternating-current system connected to the alternating-current side of the power converter; and
adjusting, according to the type of the alternating-current system, a safety protection threshold of the power converter.

In an embodiment, when the insulation detection requirement is the requirement for detecting the insulation impedance between the alternating-current side neutral point of the power converter and the ground, after calculating the insulation impedance under the insulation detection requirement, the method further includes:
determining, according to sampling values of three phase grid voltages and the calculated insulation impedance between the alternating-current side neutral point of the power converter and the ground, a type of an alternating-current system connected to the alternating-current side of the power converter; and
adjusting, according to the type of the alternating-current system, a safety protection threshold of the power converter.

In a third aspect, an apparatus is provided according to embodiments of the present disclosure. The apparatus includes a processor and a memory. The memory is configured to store a program, an instruction, or a code. The processor is configured to execute the program, the instruction, or the code stored in the memory to implement the method according to the second aspect of the present disclosure.

In a fourth aspect, a non-transitory computer readable storage medium storing a computer program is provided according to a fourth aspect of the present disclosure. The computer program is loaded by a processor to execute the insulation detection method for a power converter according to the second aspect or any implementation in the second aspect.

According to the above technical solutions, in the power converter provided in the present application, a switch is arranged between a node at which two alternating-current switches in any one phase of the alternating-current side of the power converter are connected in series to each other and a virtual neutral point of the alternating-current side. The switch may be turned on under control along with a second alternating-current switch connected thereto, to provide an alternating-current side detection loop for detecting the insulation impedance to ground of an alternating-current side neutral point. The switch may also be turned on under control along with a first alternating-current switch connected thereto and at least one switching transistor in the power converter, to provide a direct-current side detection loop for detecting the insulation impedance of the direct-current side. That is, in the present application, a direct-current side insulation detection function and an alternating-current side insulation detection function for the power converter can be achieved by the insulation detection circuit including the switch. Thus, the cost of the insulation detection can be reduced compared with the conventional technology, which requires two separate apparatuses to achieve the insulation detection function for the direct-current side and the alternating-current side respectively.

### BRIEF DESCRIPTION OF THE DRAWINGS

In conjunction with the drawings and with reference to the following implementations, the above and other features, advantages and aspects of the embodiments of the present disclosure will become more apparent. Throughout the drawings, the same or similar reference numerals denote the same or similar elements. It should be understood that, the drawings are illustrative, and the components and elements are unnecessarily drawn to scale.
FIG. 1 is a schematic structural diagram of a grid-connected inverter and an insulation detection circuit thereof according to an embodiment of the present disclosure;
FIG. 2 is a schematic structural diagram of a power converter and an insulation detection circuit thereof according to another embodiment of the present disclosure;
FIG. 3 is a schematic diagram of an alternating-current side detection loop for detecting the insulation impedance between an alternating-current side neutral point and ground according to the structure shown in FIG. 2;
FIG. 4 is a schematic diagram of a direct-current side positive electrode detection loop for detecting the insulation impedance between a positive electrode of the direct-current side and ground according to the structure n shown in FIG. 2;
FIG. 5 is a schematic diagram of a direct-current side negative electrode detection loop for detecting the insulation impedance between a negative electrode of the direct-current side and ground according to the structure shown in FIG. 2;
FIG. 6 is a schematic structural diagram of a power converter and an insulation detection circuit thereof according to another embodiment of the present disclosure;
FIG. 7 is a schematic diagram of a connection relationship of an insulation detection circuit according to an embodiment of the present disclosure;
FIG. 8 is a schematic diagram of a connection relationship of an insulation detection circuit according to another embodiment of the present disclosure;
FIG. 9 is a schematic diagram of a connection relationship of an insulation detection circuit according to another embodiment of the present disclosure;
FIG. 10 is a schematic structural diagram of a power converter and an insulation detection circuit thereof according to another embodiment of the present disclosure;
FIG. 11 is a schematic structural diagram of a power converter according to another embodiment of the present disclosure;
FIG. 12 is a schematic diagram of a specific structure of a power converter according to an embodiment of the present disclosure;
FIG. 13 is a schematic diagram of an alternating-current side detection loop for detecting the insulation impedance between an alternating-current side neutral point and ground according to the structure shown in FIG. 12;
FIG. 14 is a schematic diagram of a direct-current side positive electrode detection loop for detecting the insulation impedance between a positive electrode of the direct-current side and ground according to the structure shown in FIG. 12;
FIG. 15 is a schematic diagram of another direct-current side positive electrode detection loop for detecting the insulation impedance between a positive electrode of the direct-current side and ground according to the structure shown in FIG. 12;
FIG. 16 is a schematic diagram of another direct-current side positive electrode detection loop for detecting the insulation impedance between a positive electrode of the direct-current side and ground according to the structure shown in FIG. 12;
FIG. 17 is a schematic diagram of a direct-current side negative electrode detection loop for detecting the insulation impedance between a negative electrode of the direct-current side and ground according to the structure shown in FIG. 12;
FIG. 18 is a schematic diagram of another direct-current side negative electrode detection loop for detecting the insulation impedance between a negative electrode of the direct-current side and ground according to the structure shown in FIG. 12;
FIG. 19 is a schematic diagram of another direct-current side negative electrode detection loop for detecting the insulation impedance between a negative electrode of the direct-current side and ground according to the structure shown in FIG. 12;
FIG. 20 is a flowchart of a method for insulation detection of a power converter according to an embodiment of the present disclosure;
FIG. 21 is a flowchart of a method for insulation detection of a power converter according to another embodiment of the present disclosure; and
FIG. 22 is a schematic structural diagram of an apparatus according an embodiment of the present disclosure.

### DETAILED DESCRIPTION

The embodiments of the present disclosure are described below in conjunction with the drawings in the embodiments of the present disclosure. The terms in the embodiments of the present disclosure are only for the purpose of explaining specific embodiments of the present disclosure, rather than limiting the present disclosure.

The embodiments of the present disclosure are described below with reference to the drawings. Apparently, the described embodiments are only some rather than all of the embodiments of the present disclosure. All the other embodiments obtained by those skilled in the art based on the embodiments in the present application without any creative work belong to the protection scope of the present disclosure. Those skilled in the art should understand that the technical solutions according to the embodiments of the present disclosure are still applicable to similar technical problems, despite the development of technologies and the emergence of new scenarios.

In the specification, claims, and accompanying drawings of the present disclosure, the terms "first", "second", and so on are merely for distinguishing similar objects rather than describing a specific order or sequence. It should be understood that the terms used in this way are interchangeable in an appropriate case, and this is merely a differentiation manner used when objects having a same attribute are described in the embodiments of the present disclosure. In addition, the terms "comprise", "have" and any other variants thereof are intended to cover the non-exclusive inclusion, so that a process, method, system, product, or device that includes a series of units is not necessarily limited to those units, but may include other units not expressly listed or inherent to such a process, method, product, or device.

A power converter is provided according to embodiments of the present disclosure, to reduce the detection cost of the insulation detection to ground of an alternating-current side and a direct-current side. The specific solution is as follows.

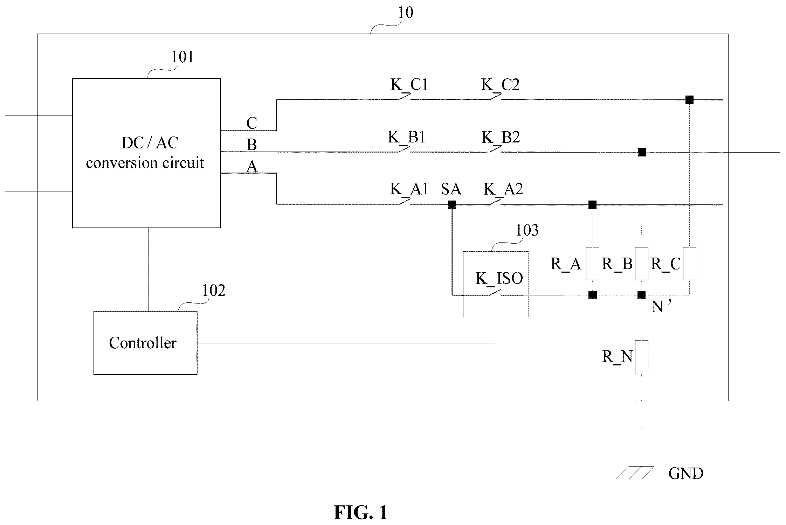

As shown in FIG. 1, the power converter 10 includes: a controller 102, a DC/AC conversion circuit 101, at least one sampling resistor (R_A, R_B, or R_C as shown in FIG. 1), an insulation resistor R_N to ground, and an insulation detection circuit 103.

The direct-current side of the DC/AC conversion circuit 101 is configured to connect a direct-current side of the power converter 10. The direct-current side of the power converter 10 is configured to connect a direct-current power supply. The direct-current power supply may refer to a photovoltaic unit, such as a photovoltaic module or a photovoltaic string. The direct-current power supply may also refer to an energy storage unit, such as a battery cluster or a battery pack or the like. The specific implementation of the direct-current power supply is not limited herein, depending on the application environment. All implementations fall within the protection scope of the present disclosure.

The alternating-current side of the DC/AC conversion circuit 101 may be configured to transmit three-phase alternating-current power or single-phase alternating-current power. FIG. 1 shows an example of transmitting three-phase alternating-current power. Each phase of the alternating-current side of the DC/AC conversion circuit 101 is sequentially connected to a corresponding phase of the alternating-current side of the power converter 10 through a corresponding first alternating-current switch and a corresponding second alternating-current switch. Specifically, a phase A of the alternating-current side of the DC/AC conversion circuit 101 is sequentially connected to a phase A of the alternating-current side of the power converter 10 through a first alternating-current switch K_A1 and a second alternating-current switch K_A2. A phase B of the alternating-current side of the DC/AC conversion circuit 101 is sequentially connected to a phase B of the alternating-current side of the power converter 10 through a first alternating-current switch K_B1 and a second alternating-current switch K_B2. And a phase C of the alternating-current side of the DC/AC conversion circuit 101 is sequentially connected to a phase C of the alternating-current side of the power converter 10 through a first alternating-current switch K_C1 and a second alternating-current switch K_C2.

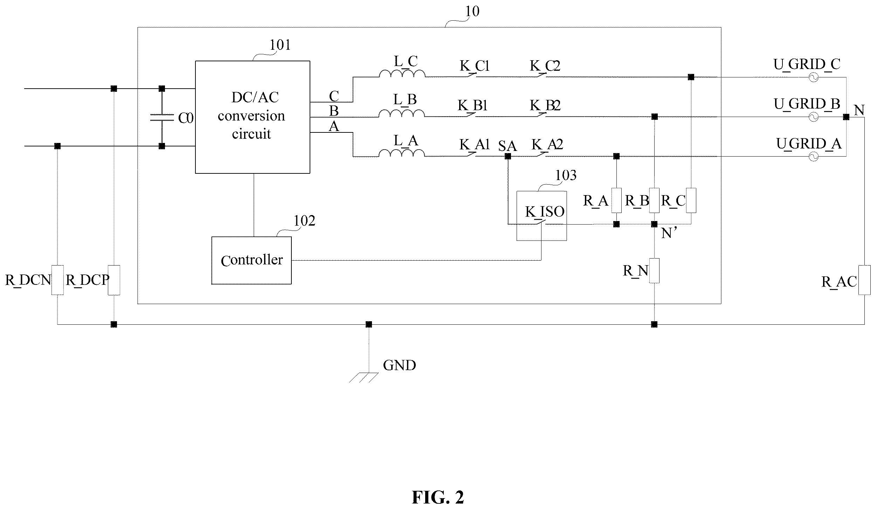

In practical applications, the power converter 10 may further include at least one alternating-current inductor (L_A, L_B, or L_C as shown in FIG. 2). In such case, each phase of the alternating-current side of the DC/AC conversion circuit 101 is sequentially connected to a corresponding phase of the alternating-current side of the power converter 10 through a corresponding alternating-current inductor, a corresponding first alternating-current switch, and a corresponding second alternating-current switch. Specifically, a phase A of the alternating-current side of the DC/AC conversion circuit 101 is sequentially connected to a phase A of the alternating-current side of the power converter 10 through an alternating-current inductor L_A, a first alternating-current switch K_A1 and a second alternating-current switch K_A2. A phase B of the alternating-current side of the DC/AC conversion circuit 101 is sequentially connected to a phase B of the alternating-current side of the power converter 10 through an alternating-current inductor L_B, a first alternating-current switch K_B1 and a second alternating-current switch K_B2. And a phase C of the alternating-current side of the DC/AC conversion circuit 101 is sequentially connected to a phase C of the alternating-current side of the power converter 10 through an alternating-current inductor L_C, a first alternating-current switch K_C1 and a second alternating-current switch K_C2.

The alternating-current side of the power converter 10 is configured to connect an external device, such as a power grid and/or a load. In this embodiment, the specific installation position of each alternating-current switch is not limited. FIG. 1 shows an example where all alternating-current switches are arranged inside the power converter 10. However, in practical applications, the alternating-current switches may also be arranged outside the power converter 10, as long as one side of each second alternating-current switch is configured to connect an external device. Installation positions of the alternating-current switches are not limited herein, which all fall within the protection scope of the present disclosure. Furthermore, when said side of the second alternating-current switch is connected to the power grid, the connection can be specifically achieved by means of a transformer. In addition, FIG. 1 shows an example where the alternating-current side of the power converter 10 transmits three-phase alternating-current power. In practical applications, the alternating-current side of the grid-connected inverter 10 may also transmit single-phase alternating-current power, and the arrangement of the alternating-current switches in this case is similar to that of the alternating-current switches described in the above embodiment, which is not repeated herein.

Each phase of the alternating-current side of the power converter 10 is connected to a virtual neutral point N' through a sampling resistor (R_A, R_B or R_C as shown in FIG. 1). The virtual neutral point N' is connected to the ground GND through an insulation resistor R_N to ground. Specifically, the virtual neutral point N' may be connected to the ground through a machine ground wire. The virtual neutral point N' refers to a neutral reference point artificially constructed by means of a topology design or a control algorithm and the like, and virtual neutral point N' is configured to provide voltage balancing or a current loop, or improve the quality of an output waveform without a physical neutral line.

The insulation detection circuit 103 includes a switch K_ISO. Two ends of the switch K_ISO are respectively connected to the virtual neutral point N' and to a connection point between two alternating-current switches in any phase (a connection point SA between a first alternating-current switch K_A1 and a second alternating-current switch K_A2 in a phase A is shown as an example in FIG. 1).

The DC/AC conversion circuit 101 and the switch K_ISO are controlled by the controller 102, but not limited to this. The switch K_ISO may also be controlled by other controllers, which depends on the specific application environment. All implementations fall within the protection scope of the present application.

In addition, the direct-current side of the DC/AC conversion circuit 101 may be connected to other devices through a direct-current bus. As shown in FIG. 2, a bus capacitor C0 may also be provided between the positive electrode and the negative electrode of the direct-current bus. The bus capacitor C0 may have a midpoint lead-out position. That is, the bus capacitor C0 may be divided into: a positive half-bus capacitor connected between the positive electrode of the direct-current bus and the midpoint of the direct-current bus, and a negative half-bus capacitor connected between the midpoint of the direct-current bus and the negative electrode of the direct-current bus.

In FIG. 2, U_GRID_A, U_GRID_B, and U_GRID_C represent a grid voltage of each phase, respectively. N represents a neutral point of a low-voltage alternating-current system of a transformer connected to the power converter 10, which may be referred to as an alternating-current neutral point for short. R_AC represents the insulation impedance between the alternating-current neutral point N and ground, which may be simply referred to as the insulation impedance between the alternating-current neutral point and ground. The direct-current side of the power converter 10 has corresponding insulation impedances. Specifically, R_DCP represents the insulation impedance between the positive electrode of the direct-current side of the power converter 10 and ground, and R_DCN represents the insulation impedance between the negative electrode of the direct-current side of the power converter 10 and ground.

The working principle is described in detail in the following.

Normally, when all switches shown in FIG. 2 are turned off, due to the symmetry of a three-phase grid voltage and the equal magnitude of sampling resistors R_A, R_B and R_C of the grid voltage, the electric potential of the virtual neutral point N' is basically consistent with that of the alternating-current neutral point N according to the equivalent circuit equivalence theorem. Therefore, sampling values of the three-phase grid voltage is basically consistent with actual values of the grid voltage, that is, U_A=U_GRID_A, U_B=U_GRID_B, U_C=U_GRID_C. Where, U_A represents the sampling value of an A-phase grid voltage, which is the voltage on the A-phase sampling resistor R_A. U_B represents the sampling value of a B-phase grid voltage, which is the voltage on the B-phase sampling resistor R_B. And U_C represents the sampling value of a C-phase grid voltage, which is the voltage on the C-phase sampling resistor R_C.

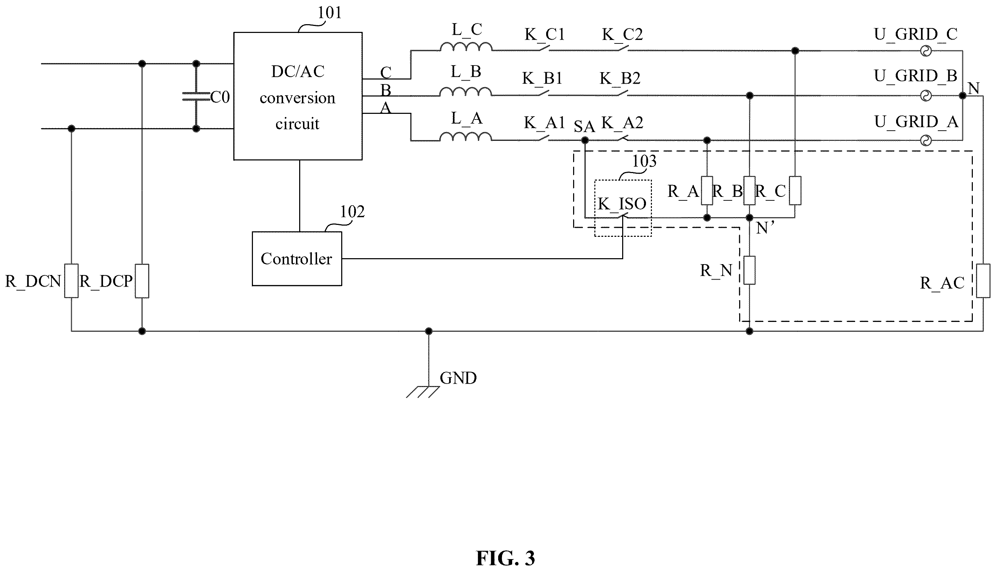

When the insulation impedance R_AC between the alternating-current side neutral point and ground is to be detected, the controller 102 may be configured to control the switch K_ISO and a second alternating-current switch (K_A2 as shown in FIG. 3) connected thereto to be turned on, to reduce the resistance value between a phase (phase A as shown in FIG. 3) and the virtual neutral point N'. Thus, the electric potential of the virtual neutral point N' is no longer consistent with that of the alternating-current neutral point N, and then an alternating-current side detection loop (a loop as shown by a dashed line in FIG. 3) is formed. The direction of the current in the alternating-current side detection loop changes with the change in the phase of the grid voltage, and thus the direction of the current is not indicated.

Taking the situation shown in FIG. 3 as an example, in the alternating-current side detection loop: $U_N \div R_N = U_GRID_A \div \left(R_N+R_AC\right) .$

Therefore, it may be derived: $R_AC = \left(U_GRID_A\div U_N\right) \times R_N - R_N .$

Where, U_N represents the voltage between the virtual neutral point N' and ground, which is the voltage on the insulation resistor R_N to ground. In addition, the resistance value of the insulation resistor R_N to ground is known, and the voltage U_N across the insulation resistor R_N to ground can be detected. Although the A-phase grid voltage U_GRID_A may no longer be represented by the sampling value U_A of the A-phase grid voltage, it can be calculated based on the sampling values U_B and U_C of grid voltages the other two phases. Therefore, in the above equation of the insulation impedance R_AC between the alternating-current side neutral point and ground, parameters on the right side of the equal sign are all known quantities, such that the insulation impedance R_AC between the alternating-current side neutral point and ground can be calculated.

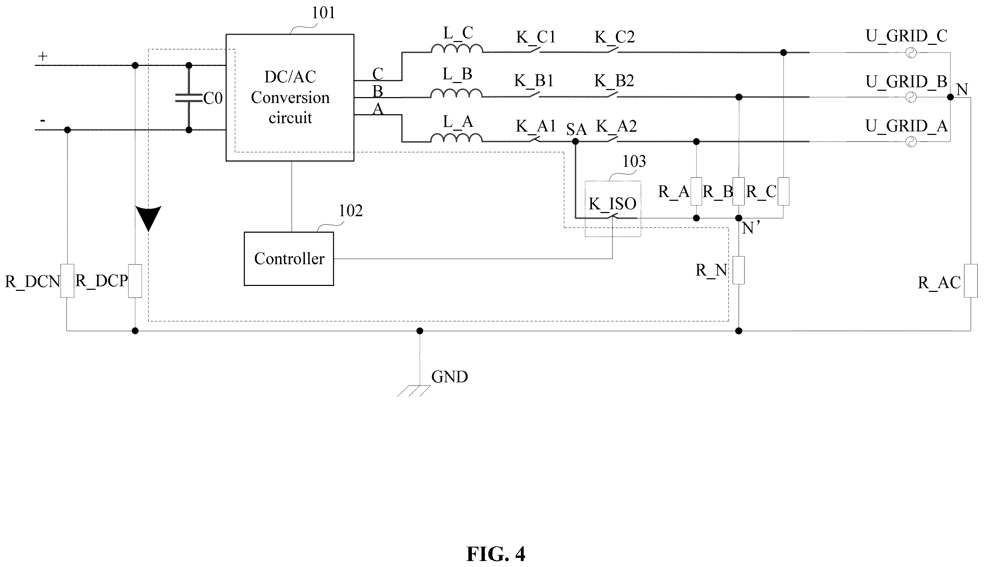

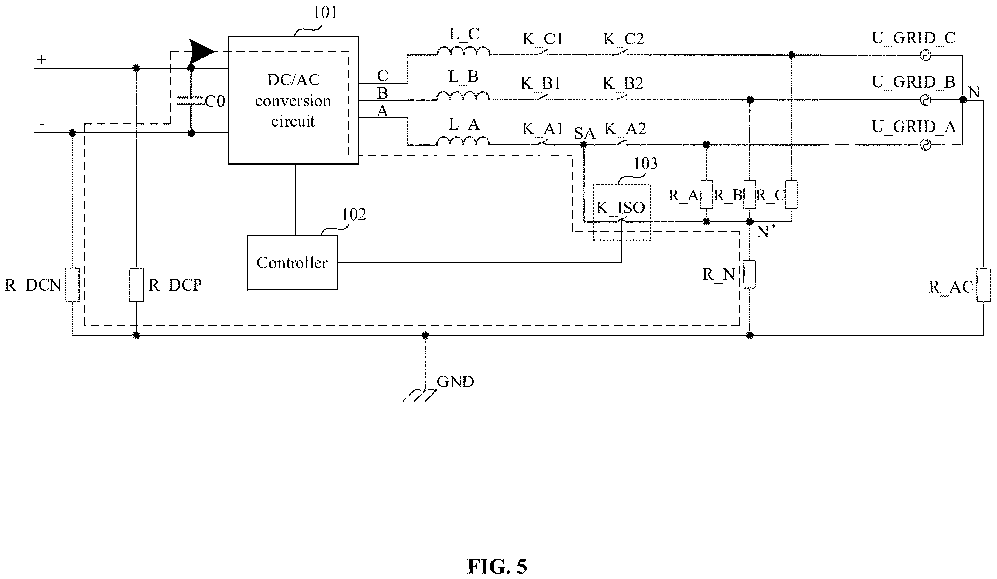

When the insulation impedances R_ DCP and R_DCN of the direct-current side of the power converter 10 is to be detected, the controller 102 may be configured to control the switch K_ISO, a first alternating-current switch (K_A1 as shown in FIGS. 4 and 5) connected thereto and at least one switching transistor in the power converter 10 to be turned on, to form a direct-current side detection loop. The direct-current side detection loop includes: a direct-current side positive electrode detection loop (a loop as shown by a dashed line with an arrow in FIG. 4) for the insulation impedance R_DCP between the positive electrode of the direct-current side and ground, and a direct-current side negative detection loop (a loop as shown by a dashed line with an arrow in FIG. 5) for the insulation impedance R_DCN between the negative electrode of the direct-current side and formed, which are formed successively. Furthermore, in the present embodiment, a sequential order of forming the direct-current side positive electrode detection loop and the direct-current side negative electrode detection loop is not limited, depending on the specific application environment. Possible orders both fall within the protection scope of the present application.

As shown in FIG. 4, in the direct-current side positive electrode detection loop for detecting the insulation impedance R_DCP between the positive electrode of the direct-current side and ground: $U_N \div R_N = U_BUS \div \left(R_N+R_DCP\right) .$

Therefore, it may be derived: $R_DCP = \left(U_BUS\div U_N\right) \times R_N - R_N .$

Where, U_BUS represents a bus voltage, which is the voltage on a bus capacitor C0, and can be detected. Therefore, in the above equation for calculating the insulation impedance R_DCP between the positive electrode of the direct-current side and ground, parameters on the right side of the equal sign are all known quantities, such that the insulation impedance R_DCP the positive electrode of the direct-current side and ground can be calculated. FIG. 4 shows an example where the bus voltage U_BUS functions as a power supply in the direct-current side positive electrode detection loop. In practical applications, in accordance with the topology configuration employed in the DC/AC conversion circuit 101, a half-bus voltage may also function as the power supply in the direct-current side positive electrode detection loop by selecting a respective switching transistor to be turned on. For details, reference is made to the following description.

As shown in FIG. 5, in the direct-current side negative electrode detection loop for detecting the insulation impedance R_DCN between the negative electrode of the direct-current side and ground: $U_N \div R_N = U_BUS \div \left(R_N+R_DCN\right) .$

Therefore, it may be derived: $R_DCN = \left(U_BUS\div U_N\right) \times R_N - R_N .$

Similarly, the half-bus voltage may also function as a power supply in the direct-current side negative electrode detection loop. For details, reference is made to the following description.

In the power converter 10 provided in this embodiment, the switch K_ISO may be controlled to be turned on while a second alternating-current switch connected thereto being turned on, to provide an alternating-current side detection loop for detecting the insulation impedance between the alternating-current side neutral point and ground. And the switch K_ISO may also be controlled to be turned on while both a first alternating-current switch connected thereto and at least one switching transistor in the power converter 10 being turned on, to provide a direct-current side detection loop for detecting the insulation impedance of the direct-current side. That is, in the present embodiment, the direct-current side insulation detection function and the alternating-current side insulation detection function for the power converter 10 can be achieved by the insulation detection circuit 103. Thus, the cost of insulation detection can be reduced compared with the conventional technology, which requires two separate apparatuses to achieve the insulation detection function for the direct-current side and the alternating-current side respectively.

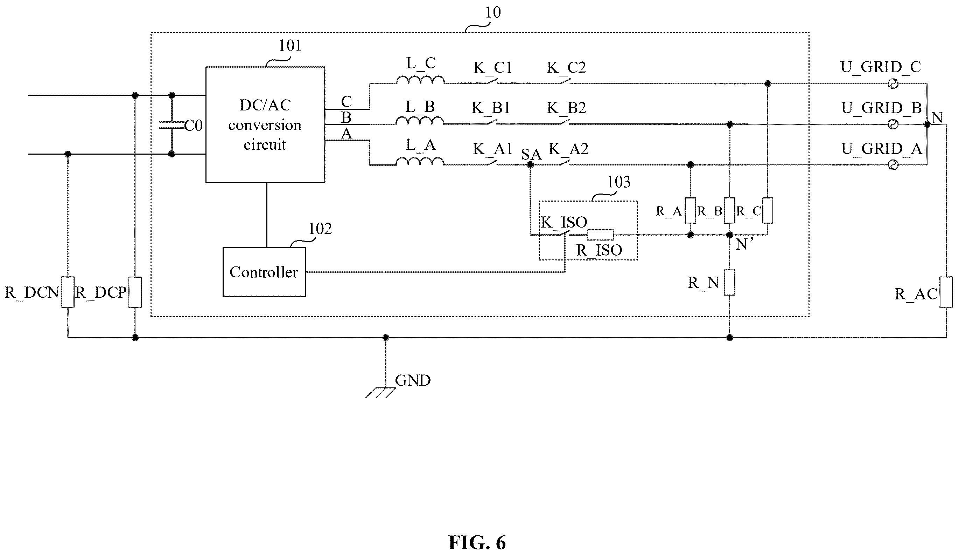

On the basis of the previous embodiment, in practical applications, the insulation detection circuit 103 may further include a first resistor R_ISO as shown in FIG.6 (based on FIG. 2). The first resistor R_ISO is connected between the switch K_ISO and the virtual neutral point N'. Alternatively, the first resistor R_ISO is connected between the switch K_ISO and a node (such as SA shown in FIG. 6) at which the corresponding two alternating-current switches are connected in series to each other. That is, as long as the first resistor R_ISO and the switch K_ISO are connected in series, the order of their series connection is not limited.

In this case, it is equivalent to adding a series resistor to the corresponding detection loop, and the resistance value of the first resistor R_ISO may be subtracted when calculating the insulation impedance.

Specifically, the equation for calculating the insulation impedance R_AC between the alternating-current side neutral point and ground becomes: $R_AC = \left(U_GRID_A\div U_N\right) \times R_N - R_N - R_ISO .$

The equation for calculating the insulation impedance R_DCP between the positive electrode of the direct-current side and ground becomes: $R_DCP = \left(U_BUS\div U_N\right) \times R_N - R_N - R_ISO .$

The equation for calculating the insulation impedance R_DCN between the negative electrode of the direct-current side and ground becomes: $R_DCN = \left(U_BUS\div U_N\right) \times R_N - R_N - R_ISO .$

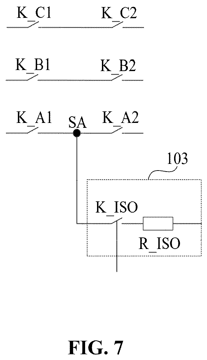

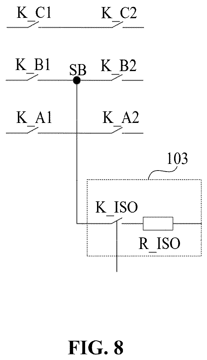

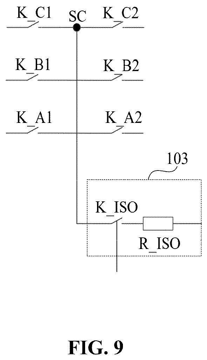

In practical applications, the insulation detection circuit 103 may be connected to any one phase of the alternating-current side of the power converter 10. Both FIGS. 6 and 7 show an example where the insulation detection circuit 103 is connected to a phase A (with the connection point being SA). FIG. 8 shows an example where the insulation detection circuit 103 is connected to a phase B (with the connection point being SB). FIG. 9 shows an example where the insulation detection circuit 103 is connected to a phase C (with the connection point being SC). The specific interconnection position depends on the actual application environment, and all possible positions fall within the protection scope of the present application. Regardless of which phase of the alternating-current side of the power converter 10 the insulation detection circuit 103 is specifically connected to, in order to form the alternating-current side detection loop, a first alternating-current switch connected to the switch K_ISO is controlled to be turned off, and the state of each alternating-current switch of other phases is not limited. Similarly, in order to form the direct-current side detection loop, a second alternating-current switch connected to the switch K_ISO is controlled to be turned off , and the state of each alternating-current switch of other phases is not limited. However, in this case, other switching transistors in the power converter 10 are controlled to be turned off.

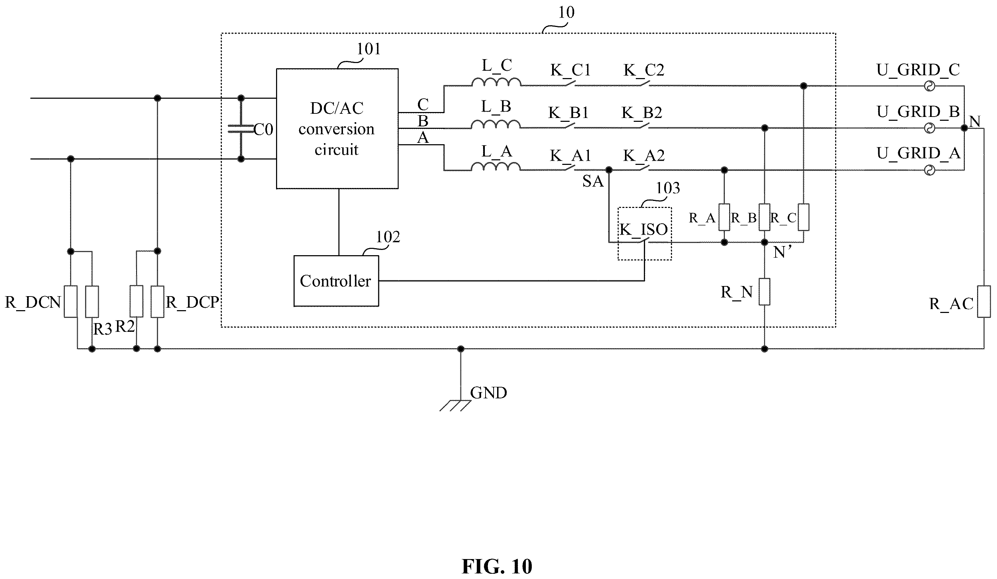

In addition, on the basis of the above structure, the power converter 10 may further include: a second resistor R2 and a third resistor R3 shown in FIG. 10 (based on FIG. 2). The second resistor R2 is connected between the positive electrode of the direct-current bus of the power converter 10 and the ground. The third resistor R3 is connected between the negative electrode of the direct-current bus of the power converter 10 and the ground.

As shown in FIG. 10, the second resistor R2 is connected in parallel with the insulation impedance R_DCP between the positive electrode of the direct-current side and ground. The third resistor R3 is connected in parallel with the insulation impedance R_DCN between the negative electrode of the direct-current side and ground. In this case, between either electrode of the direct-current side and the ground, there is not only the insulation impedance between the electrode and ground, that is, the equivalent insulation resistance to ground of a preceding stage circuit of the direct-current bus or the connected direct-current power supply and other devices at the electrode, but also a known resistor, that is, the second resistor R2 or the third resistor R3. Therefore, when calculating the insulation impedance between either electrode of the direct-current side and ground, the results obtained from the above equations are a parallel resistance value of the two resistors at that electrode. Subsequently, based on the parallel resistance value and the resistance value of the known resistor (the second resistor R2 or the third resistor R3), the insulation impedance between said electrode and ground can be calculated. In practical applications, the second resistor R2 or the third resistor R3 may be implemented by a single resistor or may be implemented by multiple resistors connected in series or in parallel. Further, the implementations of the second resistor R2 and the third resistor R3 may be the same or different, depending on the specific application environment, and all implementations fall within the protection scope of the present application.

The insulation detection circuit 103 may also include the first resistor R_ISO, the second resistor R2, and the third resistor R3 at the same time, and the specific structure and calculation principle are not illustrated again.

In practical applications, in the process of an insulation fault detection performed before the power converter 10 starts to operate, the controller 102 may be configured to control the switching states of the switch K_ISO in the insulation detection circuit 103, alternating-current switches, and switching transistors inherent to the power converter 10 itself. Then the resistance value of the alternating-current and direct-current insulation impedance to ground is calculated based on the operation state parameters of the power converter 10 under different switching states, to determine whether the power converter 10 can operate safely and stably.

In the power converter 10 provided in this embodiment, the insulation detection circuit 103 includes few devices, and as few as at least only one device (i.e., the switch K_ISO) with a switching attribute to implement the direct-current insulation detection function and the alternating-current insulation detection function.

It is worth noting that in practical applications, low-voltage alternating-current systems of a transformer connected to the alternating-current side of the power converter 10 are divided into: a TN (Terre-Neutre, in which an alternating-current neutral point is directly grounded, and the exposed conductive part of the electrical apparatus is connected to the alternating-current neutral point through a protective neutral conductor or a protective conductor) system and an IT (Isolation-Terre, in which an alternating-current neutral point is not grounded or grounded through a high impedance, and the exposed conductive part of the electrical apparatus is directly grounded) system. There is a difference between protective identification thresholds for parameters such as leakage current and the like in different alternating-current systems. However, a power converter in the conventional technology is unable to identify the type of the alternating-current system independently. Consequently, an additional device is to be deployed to identify the type of the alternating-current system.

In the power converter 10 according to the present embodiment, after the insulation impedance R_AC between the alternating-current side neutral point and ground is calculated, the type of the alternating-current system connected to the alternating-current side of the power converter 10 may be determined based on the resistance value of the insulation impedance R_AC between the alternating-current side neutral point and ground. For example, when the resistance value of the insulation impedance R_AC between the alternating-current side neutral point and ground is greater than a larger preset value, it can be determined that the type of the alternating-current system is the IT system. When the resistance value of the insulation impedance R_AC between the alternating-current side neutral point and ground is close to zero, it can be determined that the type of the alternating-current system is the TN system. Furthermore, a safety protection threshold of the power converter 10, such as a determination threshold for performing leakage current protection and the like, may be adjusted based on the determined type of the alternating-current system.

That is, the power converter 10 provided in the present embodiment can not only achieve alternating-current and direct-current insulation detection, but also determine the type of the alternating-current system independently.

In addition, when the type of the alternating-current system is the IT system and a short circuit occurs between the alternating-current neutral point and ground, the calculated resistance value of the insulation impedance R_AC between the alternating-current side neutral point and ground may be less than the above preset value. When the type of the alternating-current system is the TN system and an open circuit occurs between the alternating-current neutral point and ground, the calculated resistance value of the insulation impedance R_AC between the alternating-current side neutral point and ground may be greater than the above preset value. Therefore, in practical applications, the type of the alternating-current system may be determined in conjunction with the above sampling values U_A, U_B, and U_C of a three-phase power grid. For example, if the calculated resistance value of the insulation impedance R_AC between the alternating-current side neutral point and ground is greater than the above preset value, and the sampling values U_A, U_B, and U_C of the three-phase power grid are normal, it can be determined that the type of the alternating-current system is the IT system. If the calculated resistance value of the insulation impedance R_AC between the alternating-current side neutral point and ground is less than the above preset value, and the sampling values U_A, U_B and U_C of the three-phase power grid are abnormal, it can be determined that the type of the alternating-current system is the IT system and a short circuit occurs between the alternating-current neutral point and ground. If the resistance value of the insulation impedance R_AC between the alternating-current side neutral point and ground is close to zero, and the sampling values U_A, U_B and U_C of the three-phase power grid are normal, it can be determined that the type of the alternating-current system is the TN system. If the resistance value of the insulation impedance R_AC between the alternating-current side neutral point and ground is greater than the above preset value, and the sampling values U_A, U_B and U_C of the three-phase power grid are abnormal, it can be determined that the type of the alternating-current system is the TN system and an open circuit occurs between the alternating-current neutral point and ground.

The power converter 10 provided in the present embodiment has a small insulation detection error, which can reduce the probability of false detections, and avoid affecting the normal and stable operation of the power converter 10.

In practical applications, when the type of the alternating-current system is the TN system, or when the type of the alternating-current system is the IT system and the insulation resistance value between the alternating-current neutral point and ground is low, if a short circuit to ground occurs on the direct-current side, it is easy to form a short-circuited loop between the alternating-current side, ground and the direct-current side, which results in damage to the power converter. The power converter 10 provided in this embodiment can detect such conditions in time by means of the alternating-current and direct-current insulation detection, and identify the type of the alternating-current system, such that the power converter 10 cannot pass the self-checking required for entering an operating state, thereby avoiding its damage.

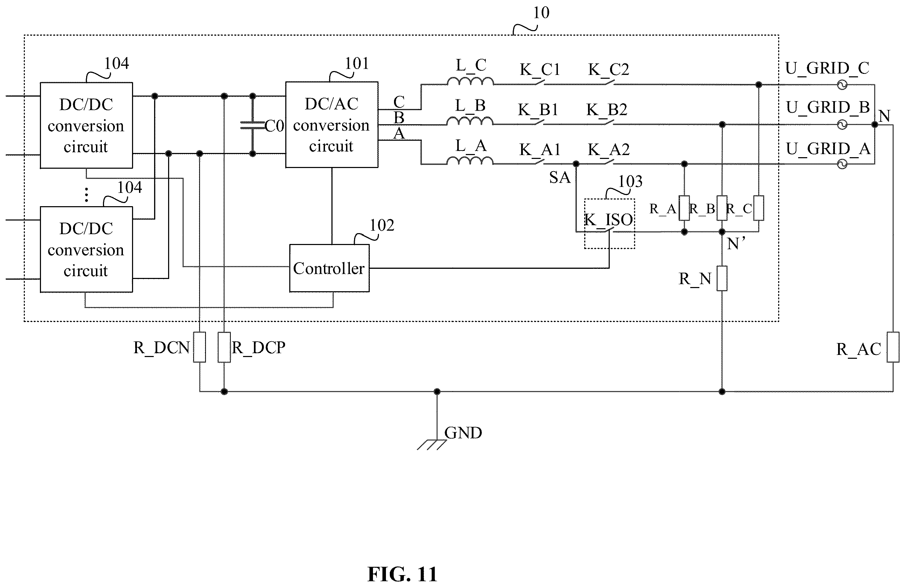

In addition, in practical applications, the power converter 10 may further include: at least one DC/DC conversion circuit 104 shown in FIG. 11 (based on FIG. 2). In this case, a first side of the DC/DC conversion circuit 104 is configured to connect to an interface at the direct-current side of the power converter 10, and the outer side of each interface is configured to connect a direct-current power supply. Each direct-current power supply may include one direct-current power supply or multiple direct-current power supplies connected in parallel. A second side of the DC/DC conversion circuit 104 is connected to the direct-current side of the DC/AC conversion circuit 101. When the quantity of the DC/DC conversion circuit 104 is greater than one, the DC/DC conversion circuits 104 are connected in parallel and connected to the direct-current side of the DC/AC conversion circuit 101 through a direct-current bus. The DC/DC conversion circuit 104 is controlled by the controller 102.

Specifically, the power converter 10 may be a PCS (Power Conversion System) or an inverter, which is not limited herein. The power converter 10 shown in FIG. 2, FIG. 6, or FIG. 10 may function as an inverter in a centralized inverter system or a distributed inverter system, and the power converter 10 shown in FIG. 11 may function as a string inverter.

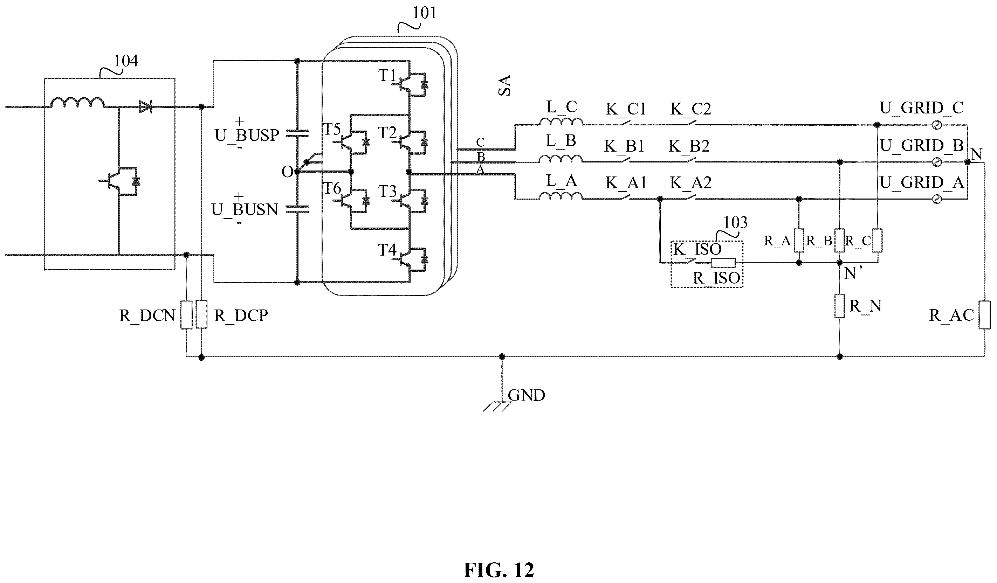

The specific implementation of the conversion circuits in the power converter 10 is not limited in this embodiment. For example, the DC/DC conversion circuit 104 that connected to a direct-current power supply which is a photovoltaic unit may be implemented by any one of a BOOST circuit, a BUCK circuit, and a BUCK-BOOST circuit. FIG. 12 shows an example where a BOOST circuit is employed. The DC/DC conversion circuit 104 that connected to a direct-current power supply which is an energy storage unit may be implemented by any one of the following: a bidirectional BUCK-BOOST circuit, a bidirectional BOOST-BUCK circuit, a bidirectional Cuk circuit, a bidirectional Sepic-Zeta circuit, a bidirectional two-bridge arm BUCK-BOOST circuit, an interleaved parallel DC-DC conversion topology, a three-phase interleaved parallel DC-DC conversion topology, a phase-shifted full-bridge topology, a full-bridge isolation voltage source topology, a full-bridge isolation current source topology, an isolation voltage source topology with a primary side half-bridge circuit and a secondary side push-pull circuit, and an isolation current source topology with a primary side push-pull circuit and a secondary side hybrid-bridge circuit.

The DC/AC conversion circuit 101 may include one single-phase inverter topology or three single-phase inverter topologies. The single-phase inverter topology may be a two-level inverter topology, or a three-level inverter topology such as NPC (Neutral Point Clamped) or ANPC (Active Neutral Point Clamped) as shown in FIG. 12 and the like. Alternatively, the single-phase inverter topology may also adopt other topologies in the conventional technology, and topologies that can realize bidirectional single-phase DC/AC conversion all fall within the protection scope of the present application. Alternatively, the DC/AC conversion circuit 101 may adopt other topologies such as a three-phase full-bridge inverter topology and the like. The selection of the topology of each conversion circuit depends on its specific application environment, and all topologies fall within the protection scope of the present application.

In FIG. 12, the ANPC three-level inverter topology includes six switching transistors T1 to T6. A switching transistor T1 may be referred to as an outer transistor at an upper bridge arm. A switching transistor T2 may be referred to as an inner transistor at the upper bridge arm. A switching transistor T3 may be referred to as an inner transistor at an lower bridge arm. A switching transistor T4 may be referred to as an outer transistor at the lower bridge arm. A switching transistor T5 may be referred to as a clamping transistor at the upper bridge arm. A switching transistor T6 may be referred to as a clamping transistor at the lower bridge arm. The selection of the switching transistors and the working principle of the topology may be referred to the conventional technology, which is not described herein in detail. In addition, in FIG. 12, U_BUSP represents a positive half-bus voltage, which is a voltage on the positive half-bus capacitor, and U_BUSN represents a negative half-bus voltage, which is a voltage on the negative half-bus capacitor.

Hereinafter, the structure shown in FIG. 12 is taken as an example to explain the insulation detection function on the alternating-current side and the direct-current side.

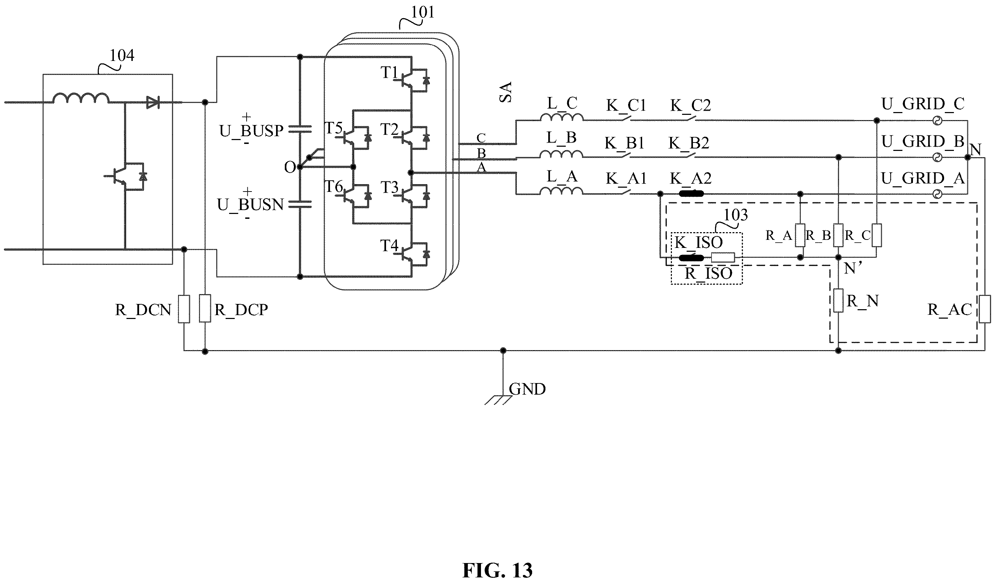

In the process of detecting the insulation impedance R_AC between the alternating-current side neutral point and ground, the switch K_ISO and a second alternating-current switch (K_A2 as shown in FIG. 12) connected thereto are turned on, to form an alternating-current side detection loop as shown by a dashed line in FIG. 13. In a case of the alternating-current side detection loop, an equation for calculating the insulation impedance R_AC between the alternating-current side neutral point and ground may be obtained as follows: $R_AC = \left(U_GRID_A\div U_N\right) \times R_N - R_N - R_ISO .$

Based on the equation, the resistance value of the insulation impedance R_AC between the alternating-current side neutral point and ground may be calculated by three-phase grid voltages U_A, U_B, U_C, a voltage U_N between the virtual neutral point N' and ground, a resistance value of the insulation resistor R_N between the virtual neutral point N' and ground, and a resistance value of the first resistor R_ISO in the insulation detection circuit 103.

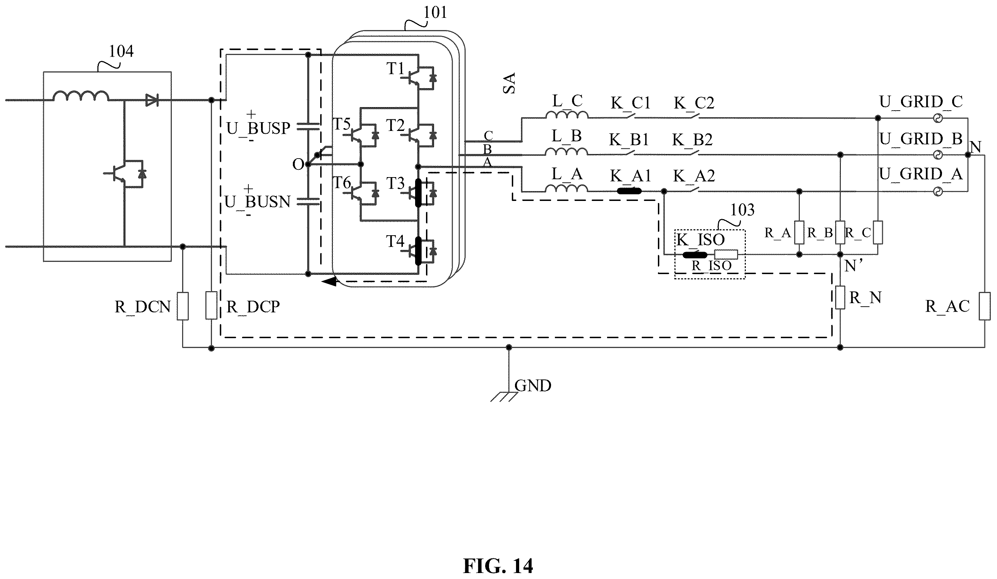

In the process of detecting the insulation impedance R_DCP between the positive electrode of the direct-current side and ground, the switch K_ISO, a first alternating-current switch (K_A1 as shown in FIG. 12) connected thereto and at least one switching transistor in the DC/AC conversion circuit 101 are turned on, to form a direct-current side positive electrode detection loop as shown by a dashed line with an arrow in FIG. 14, FIG. 15 or FIG. 16.

Referring to FIG. 14, an inner transistor T3 at the lower bridge arm and an outer transistor T4 at the lower bridge arm in the DC/AC conversion circuit 101 are turned on, to form a direct-current side positive electrode detection loop. In such case, according to the Thevenin voltage theorem, an equation for calculating the insulation impedance R_DCP between the positive electrode of the direct-current side and ground may be obtained as follows: $R _ DCP = \left(U_BUS\div U_N\right) \times R _ N - R _ N - R _ ISO .$

Based on the equation, the insulation impedance R_DCP between the positive electrode of the direct-current side and ground may be calculated by a direct-current bus voltage U_BUS, a voltage U_N between the virtual neutral point N' and ground, the resistance value of the first resistor R_ISO, and the resistance value of the insulation resistance R_N to ground.

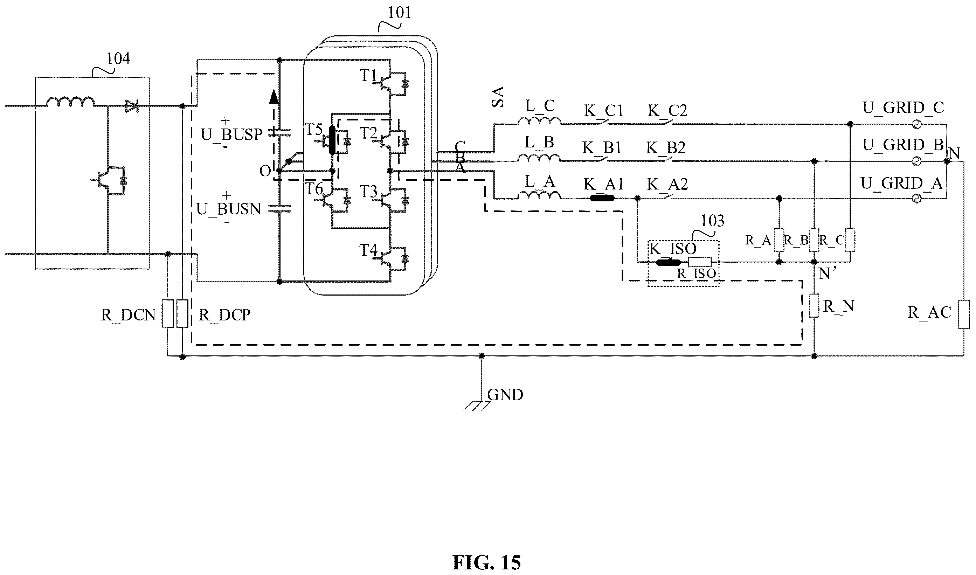

Referring to FIG. 15, a clamping transistor T5 at the upper bridge arm in the DC/AC conversion circuit 101 is turned on, to form a direct-current side positive electrode detection loop. In such case, according to the Thevenin voltage theorem, an equation for calculating the insulation impedance R_DCP between the positive electrode of the direct-current side and ground may be obtained as follows: $R _ DCP = \left(U_BUSP\div U_N\right) \times R _ N - R _ N - R _ ISO .$

Based on the equation, the insulation impedance R_DCP between the positive electrode of the direct-current side and ground may be calculated by a positive half-bus voltage U_BUSP, a voltage U_N between the virtual neutral point N' and ground, the resistance value of the first resistor R_ISO, and the resistance value of the insulation resistor R_N to ground.

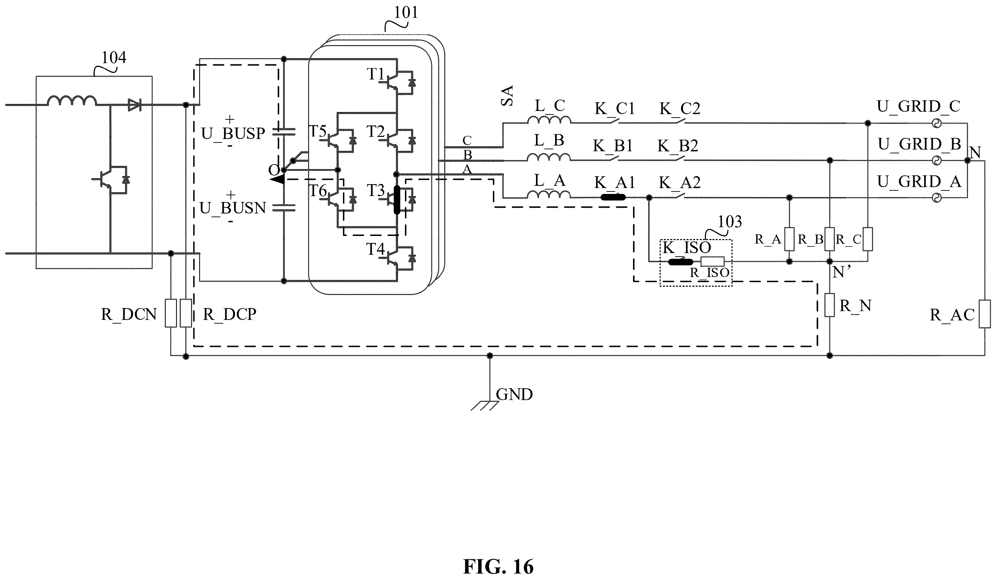

Referring to FIG. 16, an inner transistor T3 at the lower bridge arm in the DC/AC conversion circuit 101 is turned on, to form a direct-current side positive electrode detection loop. In such case, according to the Thevenin voltage theorem, an equation for calculating the insulation impedance R_DCP between the positive electrode of the direct-current side and ground may be obtained as follows: $R _ DCP = \left(U_BUSP\div U_N\right) \times R _ N - R _ N - R _ ISO .$

Based on the equation, the insulation impedance R_DCP between the positive electrode of the direct-current side and ground may be calculated by a positive half-bus voltage U_BUSP, a voltage U_N between the virtual neutral point N' and ground, the resistance value of the first resistor R_ISO, and the resistance value of the insulation resistor R_N to ground.

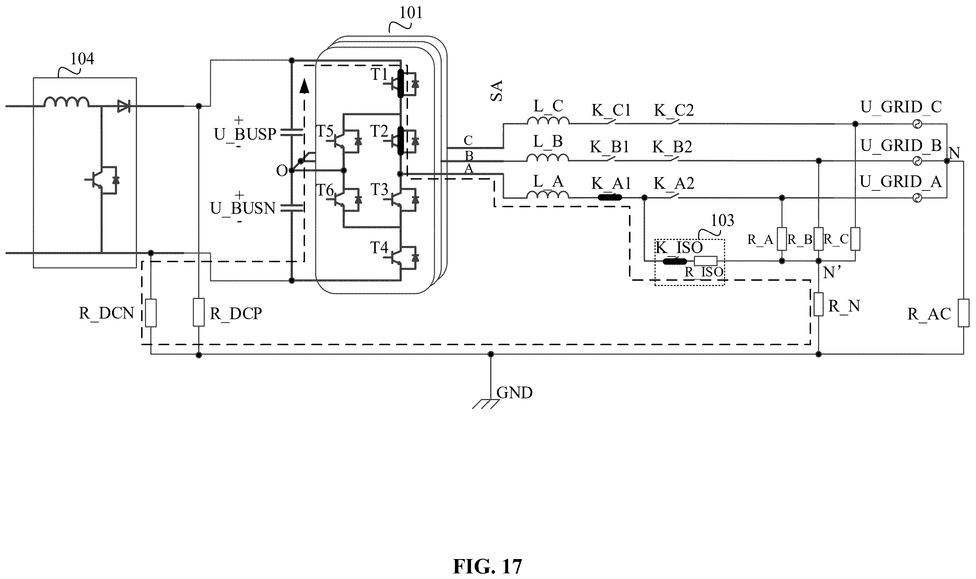

In the process of detecting the insulation impedance R_DCN between the negative electrode of the direct-current side and ground, the switch K_ISO, a first alternating-current switch (K_A1 as shown in FIG. 12) connected thereto and at least one switching transistor in the DC/AC conversion circuit 101 are turned on, to form a direct-current side positive electrode detection loop as shown by a dashed line with an arrow in FIG. 17, FIG. 18 or FIG. 19.

Referring to FIG. 17, an outer transistor T1 at the upper bridge arm and an inner transistor T2 at the upper bridge arm in the DC/AC conversion circuit 101 are turned on, to form a direct-current side negative electrode detection loop. In such case, according to the Thevenin voltage theorem, an equation for calculating the insulation impedance R_DCN between the negative electrode of the direct-current side and ground may be obtained as follows: $R _ DCN = \left(U_BUS\div U_N\right) \times R _ N - R _ N - R _ ISO .$

Based on the equation, the insulation impedance R_DCN between the negative electrode of the direct-current side and ground may be calculated by a direct-current bus voltage U_BUS, a voltage U_N between the virtual neutral point N' and ground, the resistance value of the first resistor R_ISO, and the resistance value of the insulation resistor R_N to ground.

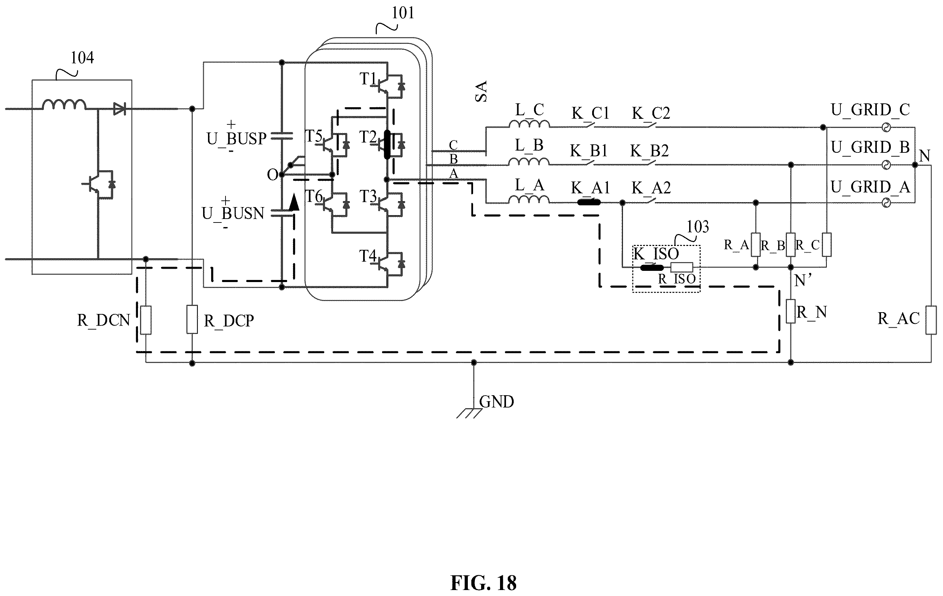

Referring to FIG. 18, an inner transistor T2 at the upper bridge arm in the DC/AC conversion circuit 101 is closed, to form a direct-current side negative electrode detection loop. In such case, according to the Thevenin voltage theorem, an equation for calculating the insulation impedance R_DCN between the negative electrode of the direct-current side and ground may be obtained as follows: $R _ DCN = \left(U_BUSN\div U_N\right) \times R _ N - R _ N - R _ ISO .$

Based on the equation, the insulation impedance R_DCN between the negative electrode of the direct-current side and ground may be calculated by a negative half-bus voltage U_BUSN, a voltage U_N between the virtual neutral point N' and ground, the resistance value of the first resistor R_ISO, and the resistance value of the insulation resistor R_N to ground.

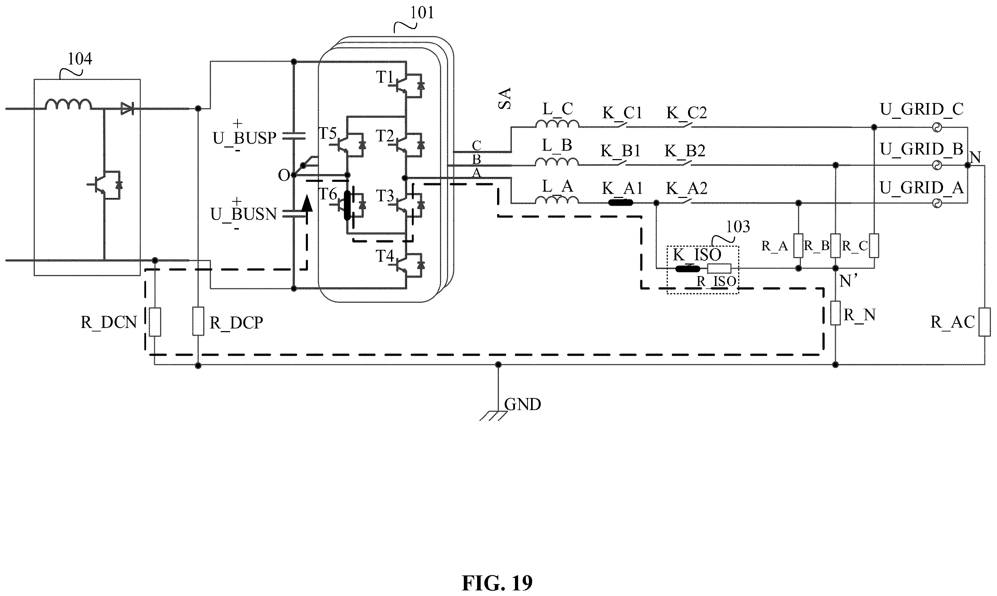

Referring to FIG. 19, a clamping transistor T6 at the lower bridge arm in the DC/AC conversion circuit 101 is closed, to form a direct-current side negative electrode detection loop. In such case, according to the Thevenin voltage theorem, an equation for calculating the insulation impedance R_DCN between the negative electrode of the direct-current side and ground may be obtained as follows: $R _ DCN = \left(U_BUSN\div U_N\right) \times R _ N - R _ N - R _ ISO .$

Based on the equation, the insulation impedance R_DCN between the negative electrode of the direct-current side and ground may be calculated by a negative half-bus voltage U_BUSN, a voltage U_N between the virtual neutral point N' and ground, the resistance value of the first resistor R_ISO, and the resistance value of the insulation resistor R_N to ground.

In practical applications, any two of the bus voltage U_BUS, the positive half-bus voltage U_BUSP and the negative half-bus voltage U_BUSN may be detected, and then the remaining voltage may be calculated based on U_BUS = U_BUSN + U_BUSP. Alternatively, the three voltages may be detected respectively as long as a resulting voltage can be obtained to perform the above calculations and such approaches all fall within the protection scope of the present application.

The principle of other topologies is similar to that in the above scenarios, and thus is not described in detail. Any solution that enables the insulation detection on the direct-current side by controlling at least one switching transistor at a bridge arm of any phase to be turned on to form the above direct-current side detection loop when performing an insulation detection on the direct-current side falls within the protection scope of the present application.

The power converter 10 provided in the present embodiment performs insulation detection on the alternating-current side and the direct-current side through the insulation detection circuit 103, which not only reduces the detection cost, but also has strong versatility and can be compatible with different types of topologies. In addition, with the above insulation detection circuit 103, the type of the alternating-current system connected thereto can be identified, to adjust a respective safety protection threshold in time.

A method for insulation detection of a power converter is also provided according to another embodiment of the present application. The method is applied to the power converter described in any of the above embodiments. The structure and working principle of the power converter may be referred to the above embodiment, which is not repeated herein. The method may be performed by a controller in the power converter or by other control apparatuses connected to the controller, all of which fall within the protection scope of the present disclosure.

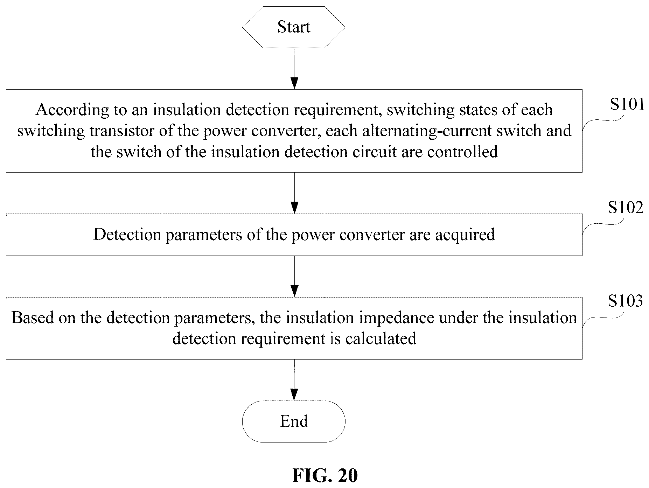

As shown in FIG. 20, the method includes the following steps.

In step S101, according to an insulation detection requirement, switching states of each switching transistor of the power converter, each alternating-current switch and the switch of the insulation detection circuit are controlled.

The insulation detection requirement is a requirement for detecting the insulation impedance of a direct-current side or the insulation impedance between an alternating-current side neutral point and ground. In practical applications, before the power converter enters its operating state, for example, during the power-on self-checking process, the insulation detection requirement may vary at different time instants, including a requirement for detecting the insulation impedance of the direct-current side and a requirement for detecting the insulation impedance between the alternating-current side neutral point and ground. Furthermore, the requirement for detecting the insulation impedance of the direct-current side includes a requirement for detecting the insulation impedance between a positive electrode of the direct-current side and ground, and a requirement for detecting the insulation impedance between a negative electrode of the direct-current side and ground.

As described in the above embodiment, under the requirement for detecting the insulation impedance between the alternating-current side neutral point and ground, the method specifically includes: the switch in the insulation detection circuit is controlled to be turned on and a second alternating-current switch connected thereto is controlled to be turned on, while all switching transistors and a first alternating-current switch connected to the switch are turned off, and the states of the alternating-current switches in other phases are not limited. Under the requirement for detecting the insulation impedance of the direct-current side, the method specifically includes: the switch in the insulation detection circuit , a second alternating-current switch connected thereto and at least one switching transistor are controlled to be turned on, while the other switching transistors and a first alternating-current switch connected to the switch are turned off, and the states of the alternating-current switches in other phases are not limited.

Under the requirement for detecting the insulation impedance between the positive electrode of the direct-current side and ground, a switching transistor to be turned on is specifically a switching transistor in a bridge arm of a corresponding phase of the DC/AC conversion circuit of the power converter that provides a direct-current side positive electrode detection loop for the insulation impedance between the positive electrode of the direct-current side and ground. For example, the switching transistor may be a clamping transistor T5 at the upper bridge arm, an inner transistor T3 at the lower bridge arm, or a combination of the inner transistor T3 and an outer transistor T4 at the lower bridge arm in the ANPC-type three-level inverter topology shown in FIG. 12.

Under the requirement for detecting the insulation impedance between the negative electrode of the direct-current side and ground, a switching transistor to be turned on is specifically a switching transistor in a bridge arm of a corresponding phase of the DC/AC conversion circuit of the power converter that provides a direct-current side negative electrode detection loop for the insulation impedance between the negative electrode of the direct-current side and ground. For example, the switching transistor may be an inner transistor T2 at the upper bridge arm, a clamping transistor T6 at the lower bridge arm, or a combination of the inner transistor T2 and an outer transistor T1 at the upper bridge arm in the ANPC-type three-level inverter topology shown in FIG. 12.

In step S102, detection parameters of the power converter are acquired.

Specifically, the detection parameters refer to voltage parameters in the above equations, such as the bus voltage U_BUS, one of the positive half-bus voltage U_BUSP and the negative half-bus voltage U_BUSN, and the voltage U_N between the virtual neutral point N' and ground.

In step S103, based on the detection parameters, the insulation impedance under the insulation detection requirement is calculated.

The specific equations may be referred to the above embodiments, which are not described herein in detail. In addition, resistance parameters required in the calculation process, such as the resistance value of the first resistor R_ISO and the resistance value of the insulation resistor R_N to ground, may be written into a controller such as the controller of the power converter in advance.

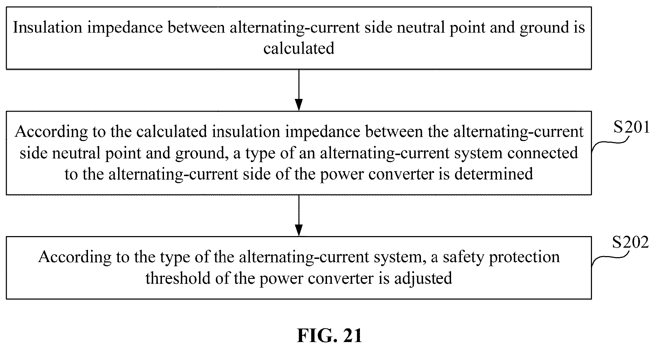

Furthermore, when the insulation detection requirement is a requirement for detecting the insulation impedance between the alternating-current side neutral point and ground, the method may include the following steps shown in FIG. 21 after step S103.

In step S201, according to the calculated insulation impedance between the alternating-current side neutral point and ground, a type of an alternating-current system connected to the alternating-current side of the power converter is determined.

The type of the alternating-current system is an IT system or a TN system. As described in the above embodiment, the type of the alternating-current system may be determined in conjunction with the above sampling values of the three-phase grid voltage, to simultaneously determine whether an open-circuit or a short-circuit fault occurs at the alternating-current neutral point.

In step S202, according to the type of the alternating-current system, a safety protection threshold of the power converter is adjusted.

The insulation detection method provided according to the present embodiment can not only achieve the insulation detection on the alternating-current side and the direct-current side, but also determine the type of the alternating-current system independently. Thus the safety protection threshold may be adjusted according to different types of the alternating-current system. In addition, it has a small detection error, which can reduce the probability of false detections and avoid affecting the normal and stable operation of the power converter.

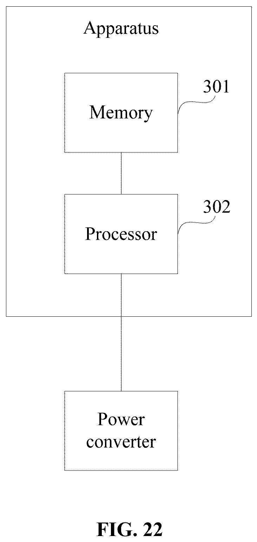

An apparatus is further provided according to another embodiment of the present disclosure. As shown in FIG. 22, the apparatus may include a memory 301 and a processor 302. The processor 302 may be connected to the power converter, and may be configured to control the switching operation of the insulation detection circuit in the power converter. In practical applications, the processor 302 may be communicatively connected to the controller in the power converter. Alternatively, the processor 302 may be connected to an output end of the voltage sampling circuit in the power converter and a control terminal of the switch in the insulation detection circuit. The connection manner of the processor 302 depends on the specific application environment, and falls within the protection scope of the present application.

Specifically, the memory 301 may be a random access memory (RAM), a flash memory, a read-only memory (ROM), an electronic programmable read-only memory (EPROM, which is a non-volatile read-only memory), a register, a hard disk, a removable disk, or the like.

The memory 301 is configured to store computer instructions. When the computer instructions stored in the memory 301 are executed by the processor 302, the processor 302 may be configured to execute the insulation detection method for a power converter according to any of the embodiments above. The memory 301 may further store data such as various equations and resistance values involved in the above embodiments.

All or part of the above embodiments may be implemented by software, hardware, firmware or any combination thereof. When implemented by software, all or some of the functions may be implemented in a form of a computer program product. The computer program product includes one or more computer instructions. When the computer program instructions are loaded and executed in a computer, all or some of the processes or functions according to the embodiments of the present disclosure are implemented. The computer may be a general-purpose computer, a special-purpose computer, a computer network, or another programmable apparatus. The computer instructions may be stored in a computer readable storage medium or transmitted from one computer readable storage medium to another computer readable storage medium. For example, the computer instructions may be transmitted from one website, computer, server or data center to another website, computer, server or data center in a wired (for example, a coaxial cable, an optical fiber or a digital subscriber line (DSL)) or wireless (for example, infrared, wireless or microwave) manner. The computer readable storage medium may be any available medium capable of being accessed by a computer or include one or more data storage devices integrated by an available medium, such as a server and a data center. The available medium may be a magnetic medium (for example, a floppy disk, a hard disk, or a magnetic tape). Alternatively, the available medium may also be a semiconductor medium (for example, a solid state disk (SSD)). The available medium may also be other medium, which is not limited herein.

A computer-readable storage medium is further provided according to another embodiment of the present disclosure. The computer-readable storage medium stores a computer program. The computer program is loaded by a processor to execute the insulation detection method for a power converter according to any embodiment describe above.

That is, the readable storage medium is configured to store the method or the algorithm provided in the above embodiments. Specifically, the readable storage medium may be a random access memory (RAM), a flash memory, a read only memory (ROM), an electrically programmable read only memory (EPROM), a register, a hard disk, a removable disk, or any other forms of storage medium in the art.

The same and similar parts among the embodiments in this specification may be referred to each other. Each of the embodiments emphasizes its differences from other embodiments. In particular, the system or system embodiment is substantially similar to the method embodiment, and therefore is described briefly. Reference may be made to the description of the method embodiment for relevant details of the system or system embodiment. The system and system embodiment described above is only illustrative, in which the units described as separate components may or may not be physically separated, and the components shown as units may or may not be physical units, that is, may be located in one place, or distributed over multiple network elements. Some or all of the modules may be selected as needed to achieve the object of the solution of the embodiments. Those skills in the art can understand and implement the solution without any creative effort.

Those skilled in the art may further understand that the units and algorithm steps of each example described in conjunction with the embodiments disclosed herein can be implemented by electronic hardware, computer software, or a combination of both. In order to clearly illustrate the interchangeability of hardware and software, the components and steps of each example have been described in general terms of functionality in the above description. Whether these functions are implemented by hardware or software depends on specific applications and design constraints for the technical solutions. Those skilled in the art may use different methods to implement the described functions for each specific application, but such implementation should not be regarded as exceeding the scope of the present disclosure.

According to the above description of the disclosed embodiments, features described in the embodiments of the present disclosure may be replaced or combined with each other, so that those skilled in the art can implement or practice the present disclosure. Various modifications made to the embodiments are apparent to those skilled in the art. The general principle defined herein may be implemented in other embodiments without departing from the scope of the present disclosure.

## Claims

1. A power converter (10), **characterized by** comprising: a controller (102), a DC/AC conversion circuit (101), an insulation resistor to ground, an insulation detection circuit (103), and at least one sampling resistor, wherein
a direct-current side of the DC/AC conversion circuit (101) is configured to connect a direct-current side of the power converter;
each phase of an alternating-current side of the DC/AC conversion circuit (101) is connected to a corresponding phase of an external device in sequence through a corresponding first alternating-current switch and a corresponding second alternating-current switch;
each phase of an alternating-current side of the power converter is connected to a virtual neutral point through a corresponding sampling resistor;
the virtual neutral point is grounded through the insulation resistor to ground;
the insulation detection circuit (103) comprises a switch, and two ends of the switch are respectively connected to the virtual neutral point and a connection point between two alternating-current switches in one phase of the DC/AC conversion circuit (101);
the DC/AC conversion circuit (101) and the switch are controlled by the controller (102); and
the switch is configured to:
be controlled to be turned on while the second alternating-current switch connected to the switch being turned on, to provide an alternating-current side detection loop for detecting the insulation impedance between an alternating-current side neutral point of the power converter and ground; and
be controlled to be turned on while the first alternating-current switch connected to the switch being turned on and at least one switching transistor in the DC/AC conversion circuit (101) being turned on, to provide a direct-current side detection loop for detecting the insulation impedance of the direct-current side of the power converter.

2. The power converter (10) according to claim 1, wherein the insulation detection circuit (103) further comprises:
a first resistor, wherein the first resistor is connected between the switch and the virtual neutral point, or, the first resistor is connected between the switch and a node at which the two alternating-current switches are connected in series to each other.

3. The power converter (10) according to claim 1 or 2, further comprising:
a second resistor and a third resistor, wherein
the second resistor is connected between a positive electrode of the direct-current side of the DC/AC conversion circuit (101) and the ground, and
the third resistor is connected between a negative electrode of the direct-current side of the DC/AC conversion circuit (101) and the ground.

4. The power converter (10) according to any one of claims 1 to 3, wherein the DC/AC conversion circuit (101) comprises:
one single-phase inverter topology;
three single-phase inverter topologies; or
a three-phase full-bridge inverter topology.

5. The power converter (10) according to any one of claims 1 to 4, further comprising:
at least one DC/DC conversion circuit (104), wherein
a first side of the DC/DC conversion circuit (104) is configured to connect to a corresponding interface of the direct-current side of the power converter;
a second side of the DC/DC conversion circuit (104) is connected to the direct-current side of the DC/AC conversion circuit (101); and
the DC/DC conversion circuit (104) is controlled by the controller (102).

6. The power converter (10) according to any one of claims 1 to 5, wherein the first alternating-current switch and the second alternating-current switch are provided inside or outside the power converter.

7. A method for insulation detection of a power converter, applied to the power converter according to any one of claims 1 to 6, **characterized in that** the method comprises:
controlling (S101), according to an insulation detection requirement, switching states of each switching transistor of the power converter, each alternating-current switch and the switch of the insulation detection circuit, the insulation detection requirement being a requirement for detecting the insulation impedance of the direct-current side of the power converter or the insulation impedance between the alternating-current side neutral point of the power converter and the ground;
acquiring (S102) detection parameters of the power converter; and
calculating (S103) the insulation impedance under the insulation detection requirement based on the detection parameters.

8. The method according to claim 7, wherein the insulation detection requirement is the requirement for detecting the insulation impedance between the alternating-current side neutral point of the power converter and the ground, the controlling the switching states of each switching transistor of the power converter, each alternating-current switch and the switch of the insulation detection circuit comprises:
controlling the switch and the second alternating-current switch connected the switch to be turned on, and controlling each switching transistor and the first alternating-current switch connected to the switch to be turned off.

9. The method according to claim 7, wherein the insulation detection requirement is the requirement for detecting the insulation impedance of the direct-current side of the power converter, the controlling the switching states of each switching transistor of the power converter, each alternating-current switch and the switch of the insulation detection circuit comprises:
controlling the switch, the first alternating-current switch connected to the switch and at least one switching transistor to be turned on, and controlling switching transistors other than said at least one switching transistor and the second alternating-current switch connected to the switch to be turned off.

10. The method according to claim 9, wherein the controlling the switch, the first alternating-current switch connected to the switch and the at least one switching transistor to be turned on comprises:
when detecting the insulation impedance between a positive electrode of the direct-current side of the power converter and the ground, controlling the switch and the first alternating-current switch connected to the switch to be turned on, and controlling a switching transistor of a bridge arm of a corresponding phase of the DC/AC conversion circuit of the power converter that provides a direct-current side positive electrode detection loop for the insulation impedance between the positive electrode of the direct-current side of the power converter and the ground to be turned on; and
when detecting the insulation impedance between a negative electrode of the direct-current side of the power converter and the ground, controlling the switch and the first alternating-current switch connected to the switch to be turned on, and controlling a switching transistor in a bridge arm of a corresponding phase of the DC/AC conversion circuit that provides a direct-current side negative electrode detection loop for the insulation impedance between the negative electrode of the direct-current side of the power converter and the ground to be turned on.

11. The method according to claim 10, wherein
the DC/AC conversion circuit comprises an ANPC-type three-level inverter topology;
the switching transistor that provides the direct-current side positive electrode detection loop for the insulation impedance between the positive electrode of the direct-current side of the power converter and the ground is: a clamping transistor at an upper bridge arm, an inner transistor at a lower bridge arm, or both an inner transistor and an outer transistor at a lower bridge arm; and
the switching transistor that provides the direct-current side negative electrode detection loop for the insulation impedance between the negative electrode of the direct-current side of the power converter and the ground is: an inner transistor at an upper bridge arm, a clamping transistor at a lower bridge arm, or both an inner transistor and an outer transistor at an upper bridge arm.

12. The method for according to any one of claims 7 to 11, wherein the insulation detection requirement varies at different time instants, comprising:
a requirement for detecting the insulation impedance of the direct-current side of the power converter; and
a requirement for detecting the insulation impedance between the alternating-current side neutral point of the power converter and the ground.

13. The method according to any one of claims 7 to 11, wherein when the insulation detection requirement is the requirement for detecting the insulation impedance between the alternating-current side neutral point of the power converter and the ground, after calculating the insulation impedance under the insulation detection requirement, the method further comprises:
determining (S201), according to the calculated insulation impedance between the alternating-current side neutral point of the power converter and the ground, a type of an alternating-current system connected to the alternating-current side of the power converter; and
adjusting (S202), according to the type of the alternating-current system, a safety protection threshold of the power converter.

14. The method according to any one of claims 7 to 11, wherein when the insulation detection requirement is the requirement for detecting the insulation impedance between the alternating-current side neutral point of the power converter and the ground, after calculating the insulation impedance under the insulation detection requirement, the method further comprises:
determining, according to sampling values of three phase grid voltages and the calculated insulation impedance between the alternating-current side neutral point of the power converter and the ground, a type of an alternating-current system connected to the alternating-current side of the power converter; and
adjusting, according to the type of the alternating-current system, a safety protection threshold of the power converter.

15. An apparatus, **characterized by** comprising:
a processor (302); and
a memory (301), wherein the memory (301) is configured to store a program, an instruction, or a code, and the processor (302) is configured to execute the program, the instruction, or the code stored in the memory (301) to implement the method according to any one of claims 7 to 14.
